# EUROPEAN PATENT SPECIFICATION

(11) **EP 2 098 879 B1**
(45) Date of publication and mention of the grant of the patent: **26.12.2012**
(21) Application number: 07831897.9
(22) Date of filing: 15.11.2007
(51) Int. Cl.: G01R 33/09, H01L 43/08, G01R 33/00

(54) **MAGNETIC DETECTING DEVICE, AND ITS MANUFACTURING METHOD**
MAGNETISCHE DETEKTIONSANORDNUNG UND HERSTELLUNGSVERFAHREN DAFÜR
DISPOSITIF DE DÉTECTION MAGNÉTIQUE ET SON PROCÉDÉ DE FABRICATION

(30) Priority: 17.11.2006 JP 2006311218
(43) Date of publication of application: 09.09.2009
(73) Proprietor: Alps Electric Co., Ltd., Ota-ku Tokyo 145-8501 (JP)
(72) Inventor: GOCHO, Hideki, Tokyo 145-8501 (JP); ANDO, Hideto, Tokyo 145-8501 (JP); HIRAYAMA, Motoki, Tokyo 145-8501 (JP)
(74) Representative: Klunker . Schmitt-Nilson . Hirsch
(86) International application number: PCT/JP2007/072167
(87) International publication number: WO 2008/059915

(56) References cited:
- JP-A- 07 226 547
- JP-A- 08 274 385
- JP-A- 2003 315 432
- JP-A- 2006 086 195
- US-A1- 2005 141 148

## Description

### Technical Field

The present invention relates to a magnetic detection device that includes, on a substrate, a magnetoresistance effect element that utilizes a magnetoresistance effect in which the electrical resistance varies by the outer magnetic field and outputs a magnetic-field detection signal based on a variation in the electrical resistance of the magnetoresistance effect element, and relates to a process of producing the same.

### Background Art

Magnetoresistance effect elements, such as GMR elements, which utilize a magnetoresistance effect in which the electrical resistance varies by an outer magnetic field, are in demand as thin-film magnetic heads built in hard disk devices as shown in the following patent documents and are in demand as magnetic detection devices (sensors) that are used, for example, as opening/closing detection sensors of folding-type mobile phones.

In the latter case, that is, in the use as a magnetic detection device, conventionally, a contact type or, in a noncontact type, for example, a Hall element is generally used. In the magnetoresistance effect element, since the resistance adequately varies even if the element is a noncontact type and the outer magnetic field is relatively weak, a high quality and a long lifetime can be expected.

In the magnetic detection device, a plurality of integrated circuits and magnetoresistance effect elements utilizing the magnetoresistance effect is formed on a substrate, and the substrate is diced into each device for forming individual chips. Then, they are packaged to form a product.

In the above-mentioned thin-film magnetic head, usually, a shielding layer, an inductive head for writing, and other layers are laminated on the magnetoresistance effect element. On the other hand, in the magnetic detection device (sensor), though the magnetoresistance effect element is covered with an insulation protection layer of an inorganic insulating material, the dicing is performed with the insulation protection layer being exposed. Therefore, a problem of corrosion is prone to occur during the manufacturing process if the magnetoresistance effect element is not securely covered with the insulation protection layer. In particular, because of the structural reasons described below, the conventional insulation protection layer has a large thickness.

With regard to background art reference is made to JP 2003-085712 A and JP06-274832 A, in general. Further, US 2005/0141148 A1 discloses a magnetic memory including a TMR magnetoresistance effect element having a magnetization pinned layer whose magnetization direction is pinned, a storage layer whose magnetization direction is changeable, and a non-magnetic layer provided between the magnetization pinned layer and the storage layer. A first writing layer is electrically connected to the magnetoresistance effect element and extends in a direction substantially perpendicular to a direction of an easy magnetization axis of the storage layer, wherein an end face of the magnetoresistance effect element substantially perpendicular to the direction of the easy magnetization axis of the storage layer and an end face of the first writing layer substantially perpendicular to the direction of the easy magnetization axis being positioned on the same plane.

### Disclosure of Invention

### Problems to be Solved by the Invention

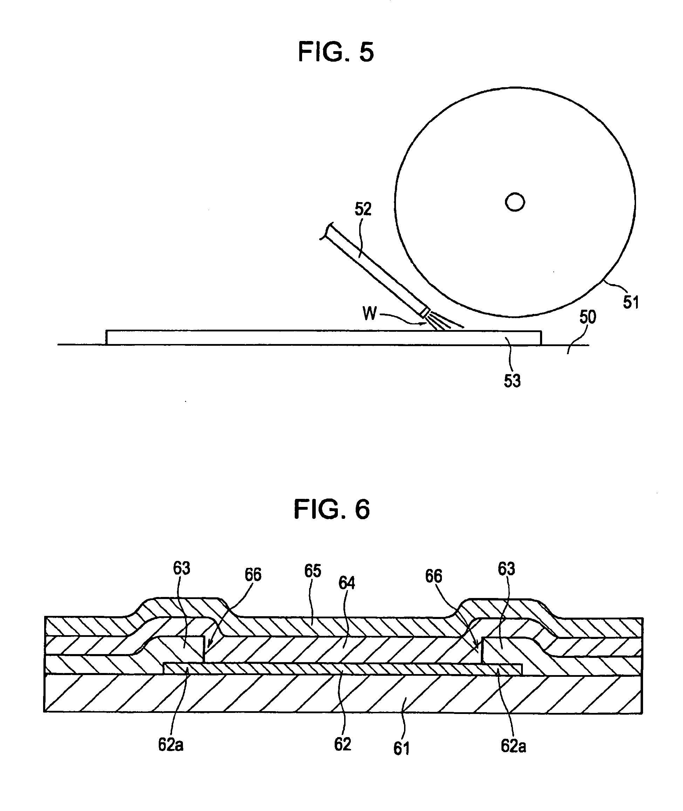

As shown in Fig. 6, electrode layers 63 and 63 are disposed on both ends 62a, respectively, of a magnetoresistance effect element 62 disposed on a substrate 61.

As shown in Fig. 6, an alumina (Al₂O₃) layer 64 is disposed on the electrode layer 63 over the magnetoresistance effect element 62, and a silica (SiO₂) layer 65 is further disposed on the alumina layer 64.

The alumina layer 64 is excellent in heat resistance and weather resistance. In particular, the alumina layer 64 inhibits oxygen permeation and thereby can adequately prevent the magnetoresistance effect element 62 from being degraded by oxidation (for example, variation of electrical resistance). However, the alumina layer 64 is low in water resistance. In particular, since the alumina layer 64 dissolves in an abrasive cleaning liquid that is used when the substrate is diced, the silica layer 65 is provided so as to overlap with the alumina layer 64 for preventing it.

However, as shown in Fig. 6, there are level difference portions 66 having a steep difference in level between the magnetoresistance effect element 62 and the electrode layers 63, and the adhesion of the alumina layer 64 near the level difference portions 66 is very poor by a shadow effect. Therefore, in order to adequately cover the magnetoresistance effect element 62 near the level difference portions 66 by the alumina layer 64, the alumina layer 64 must be formed so as to have a large thickness. This causes a problem in which the total thickness of the alumina layer 64 and the silica layer 65 becomes very large.

Specifically the alumina layer 64 is formed to have an average thickness of 1000 Å or more (1Å - 10⁻¹⁰ m) and the silica layer 65 is also formed to have a thickness of about 1000 Å. Consequently, the total thickness becomes at least 2000 Å.

Accordingly, the present invention has been accomplished for solving the conventional problems described above, and, in particular, it is an object thereof to provide a magnetic detection device whose magnetoresistance effect element is improved in environment resistance and thickness is reduced and provide a process of producing the same.

### Means for Solving the Problems

The problem is solved by the features according to the independent claims 1 and 6. Further embodiments and developments are defined in the respective dependent claims.

Accordingly, a magnetic detection device according to the present invention includes:
on a substrate, a resistance element portion having a magnetoresistance effect element that utilizes a magnetoresistance effect in which the electrical resistance varies by an outer magnetic field, and an integrated circuit being connected to the resistance element portion and outputting a magnetic-field detection signal based on a variation in the electrical resistance of the magnetoresistance effect element, wherein
the magnetoresistance effect element is covered with an alumina (Al₂O₃) layer, an electrode layer that is electrically connected to an end of the magnetoresistance effect element is disposed on the alumina layer, and a silica (SiO₂) layer is disposed on the electrode layer over the alumina layer provided on the magnetoresistance effect element.

In the present invention, the alumina layer is not formed on a face having a difference in level on a magnetoresistance effect element over an electrode layer, unlike conventional ones. That is, in the present invention, the alumina layer covers the entire top surface of the magnetoresistance effect element (excluding the connection portion with the electrode layer). The electrode layer is disposed on the alumina layer, and the silica layer is disposed on the electrode layer over the alumina layer. Thus, in the present invention, the alumina layer lies between the electrode layer and the magnetoresistance effect element in the area where the electrode layer is present and is not provided on the electrode layer with a difference in level with regard to the magnetoresistance effect element, unlike conventional ones. Therefore, the magnetoresistance effect element can be adequately insulated and protected even if the alumina layer has a thickness smaller than ever before, and the total thickness of the alumina layer and the silica layer can be smaller than ever before.

Thus, according to the present invention, an improvement in environment resistance of the magnetoresistance effect element and a reduction in thickness of the magnetic detection device can be achieved.

Furthermore, in the present invention, the resistance element portion preferably includes a fixed resistance element whose electrical resistance does not vary by an outer magnetic field. The fixed resistance element preferably has a structure having the same material layers as those of the magnetoresistance effect element with different stacking order, and, as in the magnetoresistance effect element, the fixed resistance element is preferably covered with the alumina layer, an electrode layer that is electrically connected to an end of the fixed resistance element is preferably disposed on the alumina layer, and the silica layer is preferably disposed on the electrode layer over the alumina layer provided on the fixed resistance element.

By doing so, the fixed resistance element can be also covered with a thin insulation protection layer while maintaining a satisfactory environment resistance, and thereby the magnetic detection device can be more effectively reduced in thickness.

In the present invention, the integrated circuit is preferably disposed on the substrate and covered with an insulation layer. The resistance element portion is preferably provided on the insulation layer, and the resistance element portion on the insulation layer and the integrated circuit on the substrate are preferably conductively connected to each other. By doing so, the magnetic detection device can be reduced in size, and both the integrated circuit and the resistance element portion can be adequately insulated and protected, which is preferred.

In the present invention, the alumina layer preferably has an average thickness within the range of 200 to 800 Å. In addition, the silica layer preferably has an average thickness within the range of 200 to 1200 Å.

The present invention relates to a process of producing magnetic detection devices each including, on a substrate, a resistance element portion having a magnetoresistance effect element that utilizes a magnetoresistance effect in which the electrical resistance varies by an outer magnetic field, and an integrated circuit being connected to the resistance element portion and outputting a magnetic-field detection signal based on a variation in the electrical resistance of the magnetoresistance effect element. The process includes:
(a) a step of forming a plurality of the integrated circuits and the resistance element portions on the substrate;
(b) a step of covering the magnetoresistance effect elements with an alumina (Al₂O₃) layer;
(c) a step of forming electrode layers on the alumina layer such that the electrode layers are each electrically connected to an end of the corresponding magnetoresistance effect element;
(d) a step of forming a silica (SiO₂) on the electrode layers over the alumina layer formed on the magnetoresistance effect elements; and
(e) a step of dicing the substrate for each device into the individual chips in a state in which the silica layer is exposed, while spraying an abrasive cleaning liquid.

In the present invention, since the alumina layer is formed on the magnetoresistance effect elements in the step (b) before the formation of the electrode layers, even the alumina layer having a small thickness can effectively cover the magnetoresistance effect elements.

Therefore, the total thickness of the alumina layer and the silica layer can be smaller than ever before. This can accelerate the reduction of thickness of the magnetic detection device.

In the present invention, even if the total thickness of the insulation protection layer covering the magnetoresistance effect elements is thus small, the uppermost silica layer can adequately protect the magnetoresistance effect elements from the abrasive cleaning liquid, which is used in the step (e) for dicing into the individual chips and with which the magnetic detection devices are exposed. In addition, though the alumina layer has a small thickness, it adequately covers the magnetoresistance effect elements. Therefore, the environment resistance can be adequately improved, e.g., permeation of oxygen can be adequately prevented.

Furthermore, in the present invention, the step (a) is preferably performed by the following steps:
(a-1) a step of forming a plurality of the integrated circuits on the substrate;
(a-2) a step of covering the integrated circuits with an insulation layer; and
(a-3) a step of forming a plurality of the resistance element portions on the insulation layer so as to be conductively connected to the corresponding integrated circuit.

By doing so, the magnetic detection device can be reduced in size, and both the integrated circuit and the resistance element portion can be adequately insulated and protected, which is preferred.

Furthermore, in the present invention, the resistance element portion preferably includes a fixed resistance element whose electrical resistance does not vary by an outer magnetic field and being formed of the same material layers as those of the magnetoresistance effect element with different stacking order, and, as in the magnetoresistance effect elements,
the fixed resistance elements are preferably covered with the alumina layer in the step (b);
electrode layers that are each electrically connected to an end of the corresponding fixed resistance element are preferably formed on the alumina layer in the step (c); and
the silica layer is preferably formed on the electrode layers over the alumina layer formed on the fixed resistance elements in the step (d).

By doing so, the total thickness of the insulation protection layer composed of the alumina layer and the silica layer provided on the fixed resistance elements can be reduced while maintaining satisfactory environment resistance of the fixed resistance elements. Advantages of the Invention

According to the present invention, an improvement in environment resistance of the magnetoresistance effect element and a reduction in thickness of the magnetic detection device can be achieved.

### Brief Description of Drawings

[Fig. 1] Fig. 1 is a perspective view showing a magnetic detection device of an Embodiment.
[Fig. 2] Fig. 2 is a cross-sectional view of the magnetic detection device of Fig. 1 when it is cut in the thickness (height) direction along the line II-II and viewed from the arrow direction.
[Fig. 3] Fig. 3 is a partially enlarged cross-sectional view of the magnetic detection device shown in Fig. 1 when it is cut along a magnetoresistance effect element from the line III-III in the thickness (height) direction and viewed from the arrow direction.
[Fig. 4] Fig. 4 is process drawings (each drawing is a cross-sectional view as in Fig. 2) showing a process of producing magnetic detection devices of an Embodiment.
[Fig. 5] Fig. 5 is a schematic diagram of a dicing process.
[Fig. 6] Fig. 6 is a cross-sectional view of a conventional magnetic detection device when it is cut in the thickness (height) direction.

### Reference Numerals

- 1: magnetic detection device
- 2,44: substrate
- 3: integrated circuit
- 4: resistance element portion
- 15, 16, 18, 19: electrode layer
- 17: lead layer
- 10: magnetoresistance effect element
- 20: fixed resistance element
- 21: level difference portion
- 30: inorganic insulation protection layer
- 31: alumina layer
- 32: silica layer
- 35: wiring layer
- 36 to 38: active element
- 39: resistor
- 40: insulation layer
- 41: insulation underside layer
- 42: resist layer
- 43: insulation topside layer
- 45: hole
- 50: setting table
- 51: dicing blade
- 52: nozzle
- 53: magnetic detection device assembly
- W: abrasive cleaning liquid

### Best Modes for Carrying Out the Invention

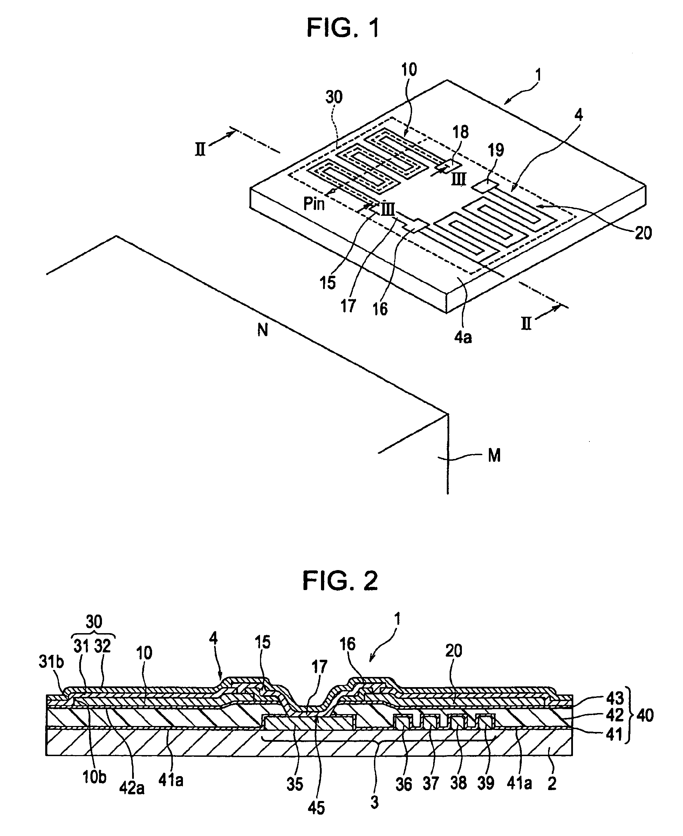

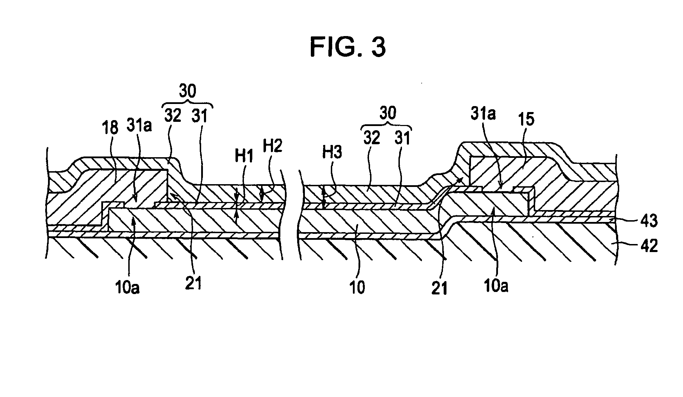

Fig. 1 is a perspective view showing a magnetic detection device of this Embodiment, Fig. 2 is a cross-sectional view of the magnetic detection device of Fig. 1 when it is cut in the thickness (height) direction along the line II-II and viewed from the arrow direction, and Fig. 3 is a partially enlarged cross-sectional view of the magnetic detection device shown in Fig. 1 when it is cut along a magnetoresistance effect element from the line III-III in the thickness (height) direction and viewed from the arrow direction.

The magnetic detection device 1 shown in Fig. 1 is an IC package in which a magnetoresistance effect element 10, a fixed resistance element 20, and an integrated circuit 3 are integrated.

In this magnetic detection device 1, when a magnetfield generating member such as a magnet M comes near the device, an ON signal (magnetic-field detection signal) is generated in the integrated circuit based on a variation in the electrical resistance of the magnetoresistance effect element 10 and is outputted.

For example, the magnetic detection device 1 shown in Fig. 1 is built in a body part, in which key switches are arranged, of a folding-type mobile phone. The folding part has a display device such as a liquid-crystal device and is mounted with a magnet M. When the body part and the folding part are in the folded state, the magnet M comes near the magnetic detection device 1, and the magnetic detection device 1 detects a magnetic field emitted from the magnet M and generates and outputs an ON signal.

The magnetoresistance effect element 10 utilizes the magnetoresistance effect to vary the electrical resistance according to an outer magnetic field. The fixed resistance element 20 does not substantially vary the electrical resistance thereof by the outer magnetic field having a magnitude to which the magnetoresistance effect element 10 reacts.

The magnetoresistance effect element 10 detects an outer magnetic field utilizing a giant magnetoresistance effect (GMR effect). The magnetoresistance effect element 10 has a basic laminate structure composed of an antiferromagnetic layer, a fixed magnetic layer, a nonmagnetic layer, and a free magnetic layer in this order from the bottom (or the stacking order of the layers may be reversed). The antiferromagnetic layer is formed of, for example, an Ir·Mn alloy (iridium/manganese alloy) or a Pt·Mn alloy (platinum/manganese alloy). The fixed magnetic layer and the free magnetic layer are each formed of, for example, a Co·Fe alloy (cobalt/iron alloy) or a Ni·Fe alloy (nickel/iron alloy). The nonmagnetic layer is formed of a nonmagnetic electrically conductive material such as Cu (copper). The magnetoresistance effect element 10 is configured by also including, for example, a protection layer and a base layer.

The fixed resistance element 20 is preferably formed of the same material layers as those of the magnetoresistance effect element 10. That is, the fixed resistance element 20 also includes, as in the magnetoresistance effect element 10, an antiferromagnetic layer, a fixed magnetic layer, a nonmagnetic layer, and a free magnetic layer, but the stacking order of the layers is different from that of the magnetoresistance effect element 10. In the fixed resistance element 20, for example, the antiferromagnetic layer, the fixed magnetic layer, the free magnetic layer, and the nonmagnetic layer are disposed in this order from the bottom (or the stacking order of the layers may be reversed). Since the free magnetic layer is thus disposed to be in contact with the fixed magnetic layer, the free magnetic layer no longer functions as a magnetic layer that varies magnetization direction thereof by an outer magnetic field, and the magnetization direction thereof is fixed as in the fixed magnetic layer. As a result, the resistance of the fixed resistance element 20 is not changed by outer magnetic field, unlike the magnetoresistance effect element 10. By forming the fixed resistance element 20 by the same material layers as those of the magnetoresistance effect element 10, the difference in the temperature coefficient (TCR) between the magnetoresistance effect element 10 and the fixed resistance element 20 can be suppressed.

The magnetoresistance effect element 10 is not limited to the GMR element and may be an AMR element utilizing an anisotropic magnetoresistance effect or a TMR element utilizing a tunnel magnetoresistance effect.

As shown in Fig. 1, the magnetoresistance effect element 10 and the fixed resistance element 20 each have a planar shape with a meander pattern and thereby have a high basic electrical resistance. The formation of the meander pattern allows a reduction in the consumption current. The magnetization of the fixed magnetic layer of the magnetoresistance effect element 10 is fixed in the Pin direction shown in Fig. 1 by an exchange coupling magnetic field that is generated between the fixed magnetic layer and the antiferromagnetic layer.

The electrical resistance of the magnetoresistance effect element 10 varies depending on the magnetization directions of the fixed magnetic layer and the free magnetic layer. When the outer magnetic field from the magnet M is antiparallel to the Pin direction of the fixed magnetic layer, the free magnetic layer is magnetized in the direction opposite to the Pin direction and exhibits the maximum electrical resistance. On the other hand, when the outer magnetic field from the magnet M is parallel to the Pin direction of the fixed magnetic layer, the free magnetic layer is magnetized in the same direction as the Pin direction and exhibits the minimum electrical resistance.

As shown in Fig. 1, an electrode layer 15 formed of a low resistance material is provided on one end of the magnetoresistance effect element 10, and an electrode layer 18 similarly formed of a low resistance material is provided on the other end of the magnetoresistance effect element 10. Similarly, an electrode layer 16 formed of a low resistance material is provided on one end of the fixed resistance element 20, and an electrode layer 19 formed of a low resistance material is also provided on the other end of the fixed resistance element 20. The electrode layer 15 of the magnetoresistance effect element 10 and the electrode layer 16 of the fixed resistance element 20 are connected to each other with a lead layer 17, and thereby the magnetoresistance effect element 10 and the fixed resistance element 20 are connected in series. In addition, the electrode layers 15 and 16 and the lead layer 17 are integrally formed.

One of the electrode layers 18 and 19 is an input terminal, and the other is an earth terminal. The lead layer 17 is an output terminal. When there is no influence of any outer magnetic field, the potential of the output terminal is the midpoint potential. When there is an influence of any outer magnetic field, the resistance value of the magnetoresistance effect element 10 varies, resulting in a variation in potential outputted from the lead layer 17. The integrated circuit 3 being connected to the lead layer 17 detects a variation in potential based on the variation in the electrical resistance of the magnetoresistance effect element 10 depending on the outer magnetic field and further generates a signal (magnetic-field detection signal) for switching between ON/OFF states based on the detection result.

As shown in Fig. 2, the magnetic detection device 1 includes a wiring layer 35, active elements 36 to 38, a resistor 39, and other components configuring the integrated circuit 3 on a substrate 2 made of, for example, silicon (Si). The active elements 36 to 38 are, for example, an IC, a differential amplifier, a comparator, and an output transistor.

The wiring layer 35 is formed of, for example, aluminum (Al). By doing so, the wiring layer 35 with low resistance can be formed.

As shown in Fig. 2, an insulation layer 40 composed of an insulation underside layer 41, a resist layer 42, and an insulation topside layer 43 stacked in this order from the bottom is disposed over the wiring layer 35, the active elements 36 to 38, the resistor 39, and the substrate 2.

The insulation layer 40 has a hole portion 45 at a position on the wiring layer 35, and the top surface of the wiring layer 35 is exposed through the hole portion 45. The planar shape of the hole portion 45 may be, for example, circular or rectangular, but is not particularly limited thereto.

As shown in Fig. 2, the insulation underside layer 41 is made of, for example, silicon nitride (SiN) and is disposed over the entire area of the wiring layer 35 excluding the hole portion 45, the active elements 36 to 38, the resistor 39, and the substrate 2. The insulation underside layer 41 is formed by, for example, sputtering.

As shown in Fig. 2, the resist layer (planarizing resist) 42 is disposed on the insulation underside layer 41. Recesses formed on the surface of the insulation underside layer 41 on the integrated circuit 3 are filled with the resist layer 42, and the surface 42a of the resist layer 42 is totally planarized compared with the surface 41a of the insulation underside layer 41. In particular, the flatness of the surface 41a of the insulation underside layer 41 is lower than that of the surface 42a of the resist layer 42 at a portion where the integrated circuit 3 is formed, whereas the surface of the insulation underside layer 41 has high flatness as in the surface 42a of the resist layer 42 at the portion where the integrated circuit 3 is not formed. The difference in level between the substrate 2 and the integrated circuit 3 covered with the insulation underside layer 41 can be at least reduced by overlaying the resist layer 42 on the insulation underside layer 41.

The insulation topside layer 43 made of, for example, silicon nitride (SiN) is disposed on the resist layer 42. By providing the insulation topside layer 43, the insulation properties can be more reliably ensured. The structure of the insulation layer 40 is not limited to the three-layer structure shown in Fig. 2. For example, it may be a two-layer structure composed of the insulation underside layer 41 and the resist layer 42.

As shown in Figs. 1 and 2, a resistance element portion 4 configured by the magnetoresistance effect element 10 and the fixed resistance element 20 is disposed on the insulation layer 40. The electrode layers 15, 16, 18, and 19 are disposed on the corresponding ends of the magnetoresistance effect element 10 and the fixed resistance element 20. As shown in Fig. 2, the lead layer 17 connecting between the electrode layer 15 of the magnetoresistance effect element 10 and the electrode layer 16 of the fixed resistance element 20 extends to the exposed surface of the wiring layer 35 through the hole portion 45. This electrically connects the magnetoresistance effect element 10 and the fixed resistance element 20 to the wiring layer 35 through the electrode layers 15 and 16 and the lead layer 17.

Furthermore, another hole portion 45 is also provided in the insulation layer 40 at a position where the electrode layer 18 of the magnetoresistance effect element 10 and the electrode layer 19 of the fixed resistance element 20 oppose to each other. The hole portion 45 has the same cross-section as that shown in Fig. 2. The magnetoresistance effect element 10 is electrically connected to a wiring layer (not shown) through the electrode layer 18, and the fixed resistance element 20 is electrically connected to the wiring layer (not shown) through the electrode layer 19.

As shown in Fig. 2, the magnetoresistance effect element 10 is covered with an inorganic insulation protection layer 30. The inorganic insulation protection layer 30 has a two-layer structure composed of an alumina (Al₂O₃) layer covering the magnetoresistance effect element 10 and a silica (SiO₂) layer 32 covering the alumina layer 31.

As shown in Figs. 2 and 3, the alumina layer 31 is disposed on the entire magnetoresistance effect element 10 excluding the ends 10a that are electrically connected to the electrode layers 15 and 18, respectively. As shown in Fig. 3, the alumina layer 31 completely covers not only the top surface but also the periphery of the side surface 10b of the magnetoresistance effect element 10 so that the magnetoresistance effect element 10 does not have an exposed portion. Therefore, as shown in Fig. 2, the alumina layer 31 is provided on the side surface 10b of the magnetoresistance effect element 10, which does not overlap with the electrode layers 15 and 18.

The alumina layer 31 is provided with through-holes 31a at positions on the ends 10a of the magnetoresistance effect element 10. The electrode layers 15 and 18 are disposed from the insides of the through-holes 31a over the alumina layer 31.

Furthermore, the silica layer 32 is disposed on the alumina layer 31 that is disposed on the magnetoresistance effect element 10 over the electrode layers 15 and 18.

In this Embodiment, the alumina layer 31 covers the magnetoresistance effect element 10 excluding the ends 10a, and the electrode layers 15 and 18 are disposed on the alumina layer 31. If the alumina layer 31 is conventionally formed on the magnetoresistance effect element 10 so as to overlap with the electrode layers 15 and 18 through the level difference portions 21, the alumina layer 31 formed by sputtering cannot adequately adhere to the area near the level difference portions 21 having steep differences due to a shadow effect. Accordingly, in order to adequately cover the magnetoresistance effect element 10 at the area near the level difference portions 21, the alumina layer 31 is required to have a large thickness.

On the other hand, in this Embodiment, the alumina layer 31 covers the entire magnetoresistance effect element 10 (excluding the portions of the through-holes 31a), and the electrode layers 15 and 18 are disposed on the alumina layer 31. Thus, in this Embodiment, the alumina layer 31, at the areas of the electrode layers 15 and 18, lies between the electrode layers 15 and 18 and the magnetoresistance effect element 10, and the alumina layer 31 is not disposed on the magnetoresistance effect element 10 so as to overlap with the electrode layers 15 and 18 through the level difference portions 21, unlike conventional cases. Therefore, even if the alumina layer 31 has a smaller thickness than ever before, the magnetoresistance effect element 10 can be adequately covered with the alumina layer 31 and can be adequately insulated and protected.

In this Embodiment, the average thickness H1 of the alumina layer 31 is preferably within the range of 200 to 800 Å. The average thickness H1 is measured for the alumina layer 31 provided on the top surface of the magnetoresistance effect element 10.

The alumina layer 31 hardly transmits oxygen and is excellent in weather resistance and heat resistance, but has a disadvantage that it dissolves in, for example, an abrasive cleaning liquid that is used during the dicing. Therefore, the silica layer 32 is disposed on the electrode layers 15 and 18 over the alumina layer 31 provided on the magnetoresistance effect element 10. The silica layer 32 is excellent in water resistance compared with the alumina layer 31. The silica layer 32 adequately covers not only the top surface but also the side surface 31b of the alumina layer 31.

As shown in Fig. 3, the silica layer 32 is formed to have a thickness H2. Here, even if the silica layer 32 has the same thickness as ever before for filling the level difference portions 21 between the magnetoresistance effect element 10 and the electrode layers 15 and 18, in this Embodiment, the total thickness H3 of the inorganic insulation protection layer 30 (= H1 + H2) as the sum of the thicknesses of the alumina layer 31 and the silica layer 32 can be smaller than ever before by forming the alumina layer 31 to be thin.

Accordingly, in the magnetic detection device 1 of this Embodiment, the total thickness H3 of the inorganic insulation protection layer 30 composed of the alumina layer 31 and the silica layer 32 can be smaller than ever before, while maintaining satisfactory environment resistance of the magnetoresistance effect element 10. The environment resistance herein is a broader concept including, for example, water resistance, heat resistance, and weather resistance (the weather resistance herein does not include water resistance).

Incidentally, in the Embodiment of Fig. 3, the electrode layers 15 and 18 are covered with only the silica layer 32. Therefore, the electrode layers 15 and 18 are desirably formed of a material having excellent environment resistance. The electrode layers 15 and 18 are preferably formed of a single material structure of, for example, Al, NiCu, Au, Cr, Ti, or Ta or a laminate structure of, for example, Ti/Au, Ta/Cr, Ta/Au/Ta, or Cr/Au/Cr.

Furthermore, the silica layer 32 can have a thickness smaller than ever before by forming the electrode layers 15 and 18 with a material having excellent environment resistance, and thereby the total thickness H3 of the inorganic insulation protection layer 30 can be further smaller compared with conventional ones. On this occasion, the average thickness H2 of the silica layer 32 is preferably within the range of 200 to 1200 Å. The average thickness H2 of the silica layer 32 is measured for the silica layer 32 provided on the top surface of the magnetoresistance effect element 10.

Furthermore, in this Embodiment, the average thickness of the magnetoresistance effect element 10 is preferably smaller than those of the electrode layers 15 and 18. By doing so, the side surface 10b of the magnetoresistance effect element 10 can be adequately covered with the alumina layer 31 even if the alumina layer 31 has a smaller thickness compared with conventional ones, and the entire magnetoresistance effect element 10 can be adequately insulated and protected by the alumina layer 31. The average thicknesses of the electrode layers 15 and 18 are preferably 1500 to 3000 Å, and the average thickness of the magnetoresistance effect element 10 is preferably 200 to 300 Å.

In addition, as shown in Fig. 2, the lead layer 17 is covered with only the silica layer 32 and, therefore, is preferably formed of a material having excellent environment resistance, as in the electrode layers 15 and 18.

In this Embodiment, as in the magnetoresistance effect element 10, the fixed resistance element 20 is preferably covered with the alumina layer 31, the electrode layers 16 and 19 that are electrically connected to the ends, respectively, of the fixed resistance element 20 are preferably disposed on the alumina layer 31, and the silica layer 32 preferably covers on the electrode layers 16 and 19 over the silica layer 32.

In particular, as described above, when the fixed resistance element 20 has a structure in which the material layers are the same as those of the magnetoresistance effect element 10 but the stacking order thereof is different, the environment resistance of the fixed resistance element 20 is low as in the magnetoresistance effect element 10. However, the environment resistance can be more effectively improved by covering the fixed resistance element 20 by the inorganic insulation protection layer 30.

Furthermore, in this Embodiment, the alumina layer 31 and the silica layer 32 are stacked on the magnetoresistance effect element 10 in this order from the bottom. If this order is reverse, the environment resistance cannot be improved.

That is, if the silica layer 32 and the alumina layer 31 are stacked in this order from the bottom, since the alumina layer 31 is low in water resistance, the layer dissolves in absorbed water. Then, since the silica layer 32 is low in weather resistance and heat resistance, when the silica layer 32 is exposed by the dissolution of the alumina layer 31, the magnetoresistance effect element 10 is corroded by, for example, the effect of oxygen through the exposed portion. Therefore, this Embodiment is limited to that the alumina layer 31 and the silica layer 32 are stacked in this order from the bottom.

In addition, in this Embodiment, though a configuration in which an integrated circuit 3 and a resistance element portion 4 are disposed in parallel in the plane direction on a substrate 2 is not excluded, as shown in Fig. 2, a configuration in which an integrated circuit 3 is disposed on a substrate 2 and is covered with an insulation layer 40 and a resistance element portion 4 is disposed on the insulation layer 40 can accelerate a reduction in size of the magnetic detection device 1 and therefore is preferred. In particular, as shown in Fig. 2, the device can have a smaller area by providing the lead layer 17 directly above the wiring layer 35, compared with the case in which the wiring layer 35 and the lead layer 17 are planarly arranged in a plane. The electrode layers 18 and 19 are also provided directly above a wiring layer (not shown). In addition, in a laminate structure as shown in Fig. 2, the integrated circuit 3 can be adequately insulated and protected, and the magnetoresistance effect element 10 can be disposed on the insulation layer 40 having a planarized surface. Therefore, the magnetoresistance effect element 10 can be formed with high precision, and thereby the magnetic detection device 1 can be reduced in size and can have excellent magnetic sensitivity.

The magnetic detection device 1 of this Embodiment shown in Figs. 1 to 3 is packaged with a resin or the like to provide a product.

According to the magnetic detection device 1 of this Embodiment, the magnetoresistance effect element 10 (and the fixed resistance element 20) can be improved in the environment resistance and can be reduced in the thickness.

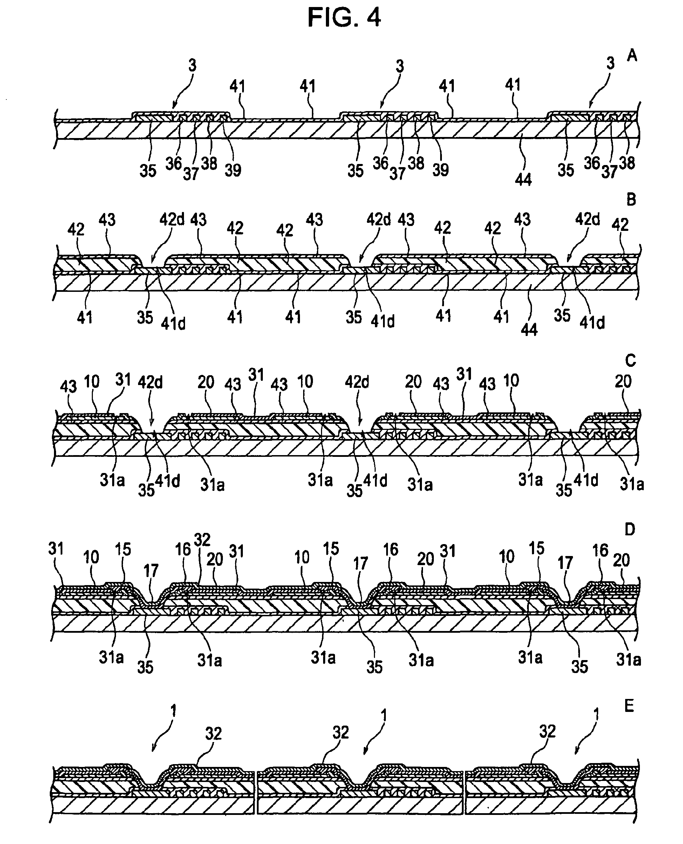

A process of producing the magnetic detection device 1 of this Embodiment will be described with reference to Fig. 4. In the step shown in Fig. 4A, a plurality of integrated circuits 3 each including a wiring layer 35, active elements 36 to 38, a resistor 39, and other components are formed on a substrate 44. The integrated circuits 3 are formed by a thin-film forming method such as CVD, sputtering, or plating.

The substrate 44 has a size that allows forming the plurality of integrated circuits 3. That is, the substrate 44 has a size larger than that of the substrate 2 in the product state shown in Figs. 1 and 2.

Then, an insulation underside layer 41 of, for example, silicon nitride (SiN) is formed over the integrated circuits 3 and the substrate 44 by sputtering or CVD.

Then, in the step shown in Fig. 4B, a resist layer 42 is applied on the insulation underside layer 41 by, for example, spin coating or screen printing, and hole portions 42d are formed by an exposure phenomenon in the resist layer 42 at positions exactly facing to the top surfaces of the wiring layers 35 in the thickness direction. Then, the insulation underside layer 41 is removed by etching at the areas that are not covered with the hole portions 42d to partially expose the wiring layers 35. The resist layer 42 is then cured by heating.

In the above-mentioned step of Fig. 4B, hole portions 41d can be easily formed also in the insulation underside layer 41 by using the resist layer 42 as a mask and etching the insulation underside layer 41 exposing through the hole portions 42d provided in the resist layer 42.

Then, an insulation topside layer 43 of, for example, Al₂O₃, SiO₂, or silicon nitride (SiN) is formed on the resist layer 42 by sputtering. The insulation topside layer 43 can be patterned not to be formed at the hole portions 41d and 42d by using, for example, a lift-off resist (not shown). The insulation topside layer 43 may not be formed.

Then, in the step of Fig. 4C, the same number of magnetoresistance effect elements 10 and fixed resistance elements 20 as that of the integrated circuits 3 are formed on the insulation topside layer 43 in predetermined shapes by a thin-film forming method such as sputtering, plating, or etching.

Then, the magnetoresistance effect elements 10 and the fixed resistance elements 20 are entirely covered with an alumina (Al₂O₃) layer 31. The alumina layer 31 is formed by sputtering and preferably has an average thickness within the range of 200 to 800 A.

Since the top surfaces of the magnetoresistance effect elements 10 and the top surfaces of the fixed resistance elements 20 are flat, even the alumina layer 31 having a small thickness can adequately cover the magnetoresistance effect elements 10 and the fixed resistance elements 20. In addition, since the thicknesses of the magnetoresistance effect elements 10 and the fixed resistance elements 20 are about 200 to 300 Å, the differences in level between the magnetoresistance effect elements 10 and the insulation topside layer 43 and between the fixed resistance elements 20 and the insulation topside layer 43 are not so large. Therefore, even the alumina layer 31 having a small thickness can adequately cover the side surfaces of the magnetoresistance effect elements 10 and the side surfaces of the fixed resistance elements 20.

As shown in Fig. 4C, the alumina layer 31 is provided with through-holes 31a to electrically connect electrode layers, which are formed in the subsequent step, to the magnetoresistance effect elements 10 or the fixed resistance elements 20. In addition, when the alumina layer 31 is also formed in the hole portions 41d and 42d formed on the wiring layers 35, the alumina layer 31 is removed to expose the wiring layers 35. The forming and removing processes of the above-mentioned through-holes 31a can be performed by etching. Alternatively, a lift-off resist layer may be provided in advance at the area where the alumina layer 31 is not formed, and the resist layer may be removed after the formation of the alumina layer 31 for adequately covering the area where the resist layer is not formed.

Then, in the step shown in Fig. 4D, electrode layers 15, 16, 18, and 19 and a lead layers 17 are formed on the through-holes 31a formed in the alumina layer 31 over the wiring layers 35, for example, by sputtering or plating. By doing so, the electrode layers 15, 16, 18, and 19 are electrically connected to the magnetoresistance effect elements 10 or the fixed resistance elements 20.

In this Embodiment, the electrode layers 15, 16, 18, and 19 and the lead layers 17 are each preferably formed of a single material structure of, for example, Al, NiCu, Au, Cr, Ti, or Ta or a laminate structure of, for example, Ti/Au, Ta/Cr, Ta/Au/Ta, or Cr/Au/Cr, which have excellent environment resistance.

Then, as shown in Fig. 4D, a silica (SiO₂) layer 32 is formed by, for example, sputtering on the electrode layers 15, 16, 18, and 19 and the lead layers 17 over the alumina layer 31 formed on the magnetoresistance effect elements 10 and the fixed resistance elements 20.

Then, for example, an exchange coupling magnetic field is generated between an antiferromagnetic layer and a fixed magnetic layer configuring each of the magnetoresistance effect elements 10, and the magnetization of the fixed magnetic layers are fixed in the Pin direction by heating treatment in a magnetic field.

In this Embodiment, since the magnetoresistance effect elements 10 are covered with the alumina layer 31 having excellent heat resistance and not transmitting oxygen under heat environment, oxidation of the magnetoresistance effect elements 10 can be adequately suppressed. Consequently, the resistance value of the magnetoresistance effect elements 10 is not varied by oxidation, and characteristic degradation can be prevented.

The heating treatment in a magnetic field and other heating treatment may be performed in a state in which the alumina layer 31 covers the surfaces of the magnetoresistance effect elements 10 not provided with the through-holes 31a.

Then, in the step shown in Fig. 4E, the substrate 44 is diced into each of the plurality of integrated circuits 3 and the resistance element portions 4 to form individual chips.

As shown in Fig. 5, in the dicing step, a magnetic detection device assembly 53 including a plurality of the magnetic detection devices that are composed of a plurality of the integrated circuits 3 and the resistance element portions 4 stacked on the substrate 44 by the sequential steps till the step shown in Fig. 4D is set on a setting table 50.

Then, the substrate 44 is cut with a dicing blade (rotating circular saw) 51. On this occasion, the dicing is performed while spraying an abrasive cleaning liquid W, such as cooling water, toward the magnetic detection device assembly 53 from a nozzle 52.

As shown in Fig. 4D, during the dicing, the uppermost layer of the magnetic detection device assembly 53 is the silica layer 32. Since the silica layer 32 has excellent water resistance, even if the silica layer 32 is exposed with the abrasive cleaning liquid W, the silica layer 32 is not corroded and does not dissolve, and thereby water does not permeate into the alumina layer 31 disposed under the silica layer 32. Therefore, the problems that the alumina layer 31 is corroded by and dissolves in the water do not occur, and the magnetoresistance effect element 10 can be adequately protected from water.

In this Embodiment, in the step shown in Fig. 4C, the magnetoresistance effect elements 10 and the fixed resistance elements 20 are covered with an alumina layer 31, and then, in the step shown in Fig. 4D, electrode layers 15, 16, 18, and 19 that are electrically connected to the magnetoresistance effect elements 10 or the fixed resistance elements 20 are formed on the alumina layer 31. Then, a silica layer 32 is formed on the electrode layers 15, 16, 18, and 19 over the alumina layer 31 formed on the magnetoresistance effect elements 10 and the fixed resistance elements 20.

Therefore, in this Embodiment, unlike a conventional case in which the alumina layer 31 is formed on the magnetoresistance effect elements 10 over the electrode layers through portions having a steep difference in level, the alumina layer 31 is formed on flat surfaces of the magnetoresistance effect elements 10 and the fixed resistance elements 20 before the formation of the electrodes layers. Therefore, the alumina layer 31 can adequately cover the magnetoresistance effect elements 10 and the fixed resistance elements 20, even if the alumina layer 31 has a thickness smaller than ever before.

The alumina layer 31 is low in water resistance. Therefore, in order to compensate this, the silica layer 32 is formed on the alumina layer 31 over the electrode layers.

In this Embodiment, as described above, since the alumina layer 31 has a thickness smaller than ever before, the total thickness of the inorganic insulation protection layer 30 composed of the alumina layer 31 and the silica layer 32 can be smaller than ever before.

From the above, according to the process of producing the magnetic detection device of this Embodiment, the environment resistance of the magnetoresistance effect element 10 (and fixed resistance element 20) can be increased, and the reduction in the thickness of the magnetic detection device 1 can be achieved.

In the step shown in Fig. 4E, the individual magnetic detection devices 1 chipped by the dicing are packaged with a mold resin to form a product.

In this Embodiment, the magnetic detection device includes one magnetoresistance effect element 10 and one fixed resistance element 20, but, for example, the magnetic detection device may include two magnetoresistance effect elements 10 and two fixed resistance elements 20 to form a bridge circuit. Such a magnetic detection device can have more excellent magnetic sensitivity and is therefore preferred.

## Claims

1. A magnetic detection device (1) comprising:
on a substrate (2; 44), a resistance element portion (4) including a magnetoresistance effect element (10) that utilizes a magnetoresistance effect in which the electrical resistance varies by an outer magnetic field, and an integrated circuit (3) being connected to the resistance element portion (4) and outputting a magnetic-field detection signal based on a variation in the electrical resistance of the magnetoresistance effect element (10), **wherein**
a side surface (10b) and an entire top surface of the magnetoresistance effect element (10) is covered with an alumina (Al₂O₃) layer (31) having respective through-holes (31 a) positioned on ends (10a) of the magnetoresistance effect element (10), each of the ends (10a) electrically connected to a respective electrode layer (15, 18) respectively disposed from the inside of the respective through-hole (31 a) on the alumina layer (31), and a silica (SiO₂) layer (32) is disposed on the electrode layers (15, 18) and the alumina layer (31) provided over the magnetoresistance effect element.

2. The magnetic detection device (1) according to Claim 1, wherein the resistance element portion (4) includes a fixed resistance element (20) whose electrical resistance does not vary by an outer magnetic field, wherein the fixed resistance element (20) has a structure having the same material layers as those of the magnetoresistance effect element (10) with different stacking order, and, as in the magnetoresistance effect element (10), a side surface and an entire top surface of the fixed resistance element (20) is covered with the alumina layer (31), respective electrode layers (16, 19) are electrically connected to respective ends of the fixed resistance element (20) and respectively disposed on the alumina layer (31), and the silica layer (32) is disposed on the electrode layers (16, 19) and the alumina layer (31) provided over the fixed resistance element (20).

3. The magnetic detection device (1) according to Claim 1 or 2, wherein the integrated circuit (3) is disposed on the substrate (2; 44) and is covered with an insulation layer (40), the resistance element portion (4) is provided on the insulation layer (40), and the resistance element portion (4) on the insulation layer (40) and the integrated circuit (3) on the substrate (2; 44) are conductively connected to each other.

4. The magnetic detection device (1) according to any of Claims 1 to 3, wherein the alumina layer (31) has an average thickness within the range of 200 to 800 Å.

5. The magnetic detection device (1) according to any of Claims 1 to 4, wherein the silica layer (32) has an average thickness within the range of 200 to 1200 Å.

6. A process of producing magnetic detection devices (1) each including, on a substrate (44), a resistance element portion (4) having a magnetoresistance effect element (10) that utilizes a magnetoresistance effect in which the electrical resistance varies by an outer magnetic field, and an integrated circuit (3) being connected to the resistance element portion (4) and outputting a magnetic-field detection signal based on a variation in the electrical resistance of the magnetoresistance effect element (10), comprising:
(a) a step of forming a plurality of the integrated circuits (3) and the resistance element portions (4) on the substrate (44);
(b) a step of covering a side surface (10b) and an entire top surface of the magnetoresistance effect elements (10) with an alumina (Al₂O₃) layer (31) having respective through-holes (31 a) positioned on respective ends (10a) of the corresponding magnetoresistance effect element (10);
(c) a step of disposing respective electrode layers (15, 18) from the inside of the respective through-hole (31 a) on the alumina layer (31) such that the electrode layers (15, 18) are each electrically connected to an respective end (10a) of the corresponding magnetoresistance effect element (10);
(d) a step of forming a silica (SiO₂) layer (32) on the electrode layers (15, 18) and the alumina layer (31) formed on the magnetoresistance effect elements; and
(e) a step of dicing the substrate (44) for each device (1) into the individual chips in a state in which the silica layer (32) is exposed, while spraying an abrasive cleaning liquid (W).

7. The process of producing magnetic detection devices (1) according to Claim 6, wherein the step (a) comprising:
(a-1) a step of forming a plurality of the integrated circuits (3) on the substrate (44);
(a-2) a step of covering the integrated circuits (3) with an insulation layer (40); and
(a-3) a step of forming a plurality of the resistance element portions (4) on the insulation layer (40) so as to be conductively connected to the corresponding integrated circuit (3).

8. The process of producing magnetic detection devices (1) according to Claim 6 or 7, wherein the resistance element portions (4) each includes a fixed resistance element (20) whose electrical resistance does not vary by an outer magnetic field, the fixed resistance elements (20) are each formed of the same material layers as those of the magnetoresistance effect element (10) with different stacking order, and, as in the magnetoresistance effect element (10),
respective side surfaces and entire top surfaces of the fixed resistance elements (20) are covered with the alumina layer (31) in the step (b);
electrode layers (16, 19) that are each connected to an end of the corresponding fixed resistance element (20) are formed on the alumina layer (31) in the step (c); and
the silica layer (32) is formed on the electrode layers (16, 19) over the alumina layer (31) formed on the fixed resistance element (20) in the step (d).

## Patentansprüche

1. Magnetische Detektionsanordnung (1) aufweisend:
auf einem Substrat (2; 44) einen Widerstandselementabschnitt (4), der ein Magnetwiderstandseffektelement (10) enthält, das einen Magnetwiderstandseffekt verwendet, bei dem der elektrische Widerstand sich durch ein äußeres Magnetfeld ändert, und einer integrierten Schaltung (3), die mit dem Widerstandselementabschnitt (4) verbunden ist und ein Magnetfelddetektionssignal basierend auf einer Änderung in dem elektrischen Widerstand des Magnetwiderstandseffektelements (10) ausgibt, wobei
eine Seitenfläche (10b) und eine gesamte Deckfläche des Magnetwiderstandseffektelements mit einer Aluminiumoxid (Al₂O₃)-Schicht (31) bedeckt ist, die jeweilige Durchgangslöcher (31a), welche an Enden (10a) des Magnetwiderstandseffektelements (10) angeordnet sind, aufweist, wobei jedes der Enden (10a) elektrisch mit einer jeweiligen Elektrodenschicht (15, 18) elektrisch verbunden ist, die jeweils aus dem Inneren des jeweiligen Durchgangslochs (31a) heraus auf der Aluminiumoxidschicht (31) angeordnet ist, und einer Siliziumoxid (SiO₂)-Schicht (32) auf den Elektrodenschichten (15, 18) angeordnet ist und die Aluminiumoxidschicht (31) über dem Magnetwiderstandselement vorgesehen ist.

2. Magnetische Detektionsanordnung (1) gemäß Anspruch 1, wobei der Widerstandselementabschnitt (4) ein Festwiderstandselement (20) aufweist, dessen elektrischer Widerstand sich nicht durch ein äußeres Magnetfeld ändert, wobei das Festwiderstandselement (20) eine Struktur aufweist, welche dieselben Materialschichten wie die des Magnetwiderstandseffektelements (10) mit unterschiedlicher Stapelreihenfolge aufweist, und wobei, wie bei dem Magnetwiderstandseffektelement (10), eine Seitenoberfläche und eine gesamte Deckschicht des Festwiderstandselements (20) mit der Aluminiumoxidschicht (31) bedeckt ist, jeweilige Elektrodenschichten (16, 19) elektrisch mit jeweiligen Enden des Festwiderstandselements (20) verbunden sind und jeweils auf der Aluminiumoxidschicht (31) angeordnet sind, und die Siliziumoxidschicht (32) auf den Elektrodenschichten (16, 19) angeordnet ist und die Aluminiumoxidschicht (31) über dem Festwiderstandselement (20) vorgesehen ist.

3. Magnetische Detektionsanordnung (1) gemäß Anspruch 1 oder 2, wobei die integrierte Schaltung (3) auf dem Substrat (2; 44) angeordnet ist und mit einer Isolationsschicht (40) bedeckt ist, der Widerstandselementabschnitt (4) auf der Isolationsschicht (40) vorgesehen ist, und der Widerstandselementabschnitt (4) auf der Isolationsschicht (40) und die integrierte Schaltung (3) auf dem Substrat (2; 44) leitend miteinander verbunden sind.

4. Magnetische Detektionsanordnung (1) gemäß einem der Ansprüche 1 bis 3, wobei die Aluminiumoxidschicht (31) eine Durchschnittsdicke innerhalb des Bereichs von 200 bis 800 Å aufweist.

5. Magnetische Detektionsanordnung (1) gemäß einem der Ansprüche 1 bis 4, wobei die Siliziumoxidschicht (32) eine Durchschnittsdicke innerhalb des Bereichs von 200 bis 1200 Å aufweist.

6. Produktionsprozess für magnetische Detektionsanordnungen (1), von denen jede aufweist auf einem Substrat (44) einen Widerstandselementabschnitt (4), der ein Magnetwiderstandseffektelement (10) aufweist, welches einen Magnetwiderstandseffekt verwendet, bei dem der elektrische Widerstand sich durch ein äußeres Magnetfeld ändert, und eine integrierte Schaltung (3), die mit dem Widerstandselementabschnitt (4) verbunden ist und ein Magnetfelddetektionssignal basierend auf einer Veränderung bei dem elektrischen Widerstand des Magnetwiderstandseffektelements (10) ausgibt, aufweisend:
(a) einen Schritt mit Ausbilden einer Vielzahl von integrierten Schaltungen (3) und den Widerstandselementabschnitten (4) auf dem Substrat (44);
(b) einen Schritt mit Abdecken einer Seitenoberfläche (10b) und einer gesamten Deckfläche des Magnetwiderstandseffektelements (10) mit einer Aluminiumoxid (Al₂O₃)-Schicht (31), welche jeweilige Durchgangslöcher (31a), die an jeweiligen Enden (10a) des zugehörigen Magnetwiderstandseffektelements (10) angeordnet sind, aufweist;
(c) einen Schritt mit Anordnen jeweiliger Elektrodenschichten (15, 18) aus dem Inneren des jeweiligen Durchgangslochs (31a) auf der Aluminiumoxidschicht (31) derart, dass die Elektrodenschichten (15, 18) jeweils elektrisch mit einem jeweiligen Ende (10a) des zugehörigen Magnetwiderstandseffektelements (10) elektrisch verbunden sind;
(d) einen Schritt mit Ausbilden einer Siliziumoxid (SiO₂)-Schicht auf den Elektrodenschichten (15, 18) und der Aluminiumoxidschicht (31), die auf den Magnetwiderstandseffektelementen ausgebildet ist; und
(e) einen Schritt mit Zerschneiden des Substrats (44) für jede Anordnung (1) in die einzelnen Chips in einen Zustand, in dem die Siliziumoxidschicht (32) freigelegt ist, während eine abrasive Reinigungsflüssigkeit (W) aufgesprüht wird.

7. Herstellungsprozess für magnetische Detektionsanordnungen gemäß Anspruch 6, wobei der Schritt (a) aufweist:
(a-1) einen Schritt mit Ausbilden einer Vielzahl der integrierten Schaltungen (3) auf dem Substrat (44);
(a-2) einen Schritt mit Abdecken der integrierten Schaltungen (3) mit einer Isolationsschicht (40); und
(a-3) einen Schritt mit Ausbilden auf der Isolationsschicht (40) einer Vielzahl der Widerstandselementabschnitte (4) derart, dass sie leitend mit der zugehörigen integrierten Schaltung (3) verbunden sind.

8. Herstellungsprozess für magnetische Detektionsanordnungen (1) gemäß Anspruch 6 oder 7, wobei die Widerstandselementabschnitte (4) jeweils ein Festwiderstandselement (20) aufweisen, dessen elektrischer Widerstand sich nicht durch ein äußeres Magnetfeld ändert, wobei die Festwiderstandselemente (20) jeweils auf derselben Materialschicht wie diejenigen des Magnetwiderstandseffektelements (10) und mit unterschiedlicher Stapelreihenfolge wie bei dem Magnetwiderstandseffektelement (10) ausgebildet sind,
wobei jeweilige Seitenflächen und Deckflächen des Festwiderstandselements (20) mit der Aluminiumoxidschicht (31) in dem Schritt (b) bedeckt werden;
wobei Elektrodenschichten (16, 19), die jeweils mit einem Ende des zugehörigen Festwiderstandselements (20) verbunden sind, auf der Aluminiumoxidschicht (31) in dem Schritt (c) ausgebildet werden; und
wobei die Siliziumoxidschicht (32) auf den Elektrodenschichten (16, 19) über der Aluminiumoxidschicht (31), die auf dem Festwiderstandselement (20) in dem Schritt (d) ausgebildet wurde, ausgebildet wird.

## Revendications

1. Dispositif de détection magnétique (1) comprenant :
sur un substrat (2 ; 44), une partie d'élément de résistance (4) comprenant un élément à effet de magnétorésistance (10) qui utilise un effet de magnétorésistance dans lequel la résistance électrique varie sous l'effet d'un champ magnétique extérieur, et un circuit intégré (3) étant connecté à la partie d'élément de résistance (4) et délivrant un signal de détection de champ magnétique basé sur une variation de la résistance électrique de l'élément à effet de magnétorésistance (10), dans lequel
une surface latérale (10b) et une surface supérieure entière de l'élément à effet de magnétorésistance (10) sont recouvertes d'une couche d'oxyde d'aluminium (Al₂O₃) (31) comportant des trous traversants respectifs (31a) positionnés sur des extrémités (10a) de l'élément à effet de magnétorésistance (10), chacune des extrémités (10a) étant connectée électriquement à une couche d'électrode respective (15, 18) disposée respectivement depuis l'intérieur du trou traversant respectif (31a) sur la couche d'oxyde d'aluminium (31), et une couche d'oxyde de silicium (SiO₂) (32) est disposée sur les couches d'électrode (15, 18) et la couche d'oxyde d'aluminium (31) placées sur l'élément à effet de magnétorésistance.

2. Dispositif de détection magnétique (1) selon la revendication 1, dans lequel la partie d'élément de résistance (4) comprend un élément à résistance fixe (20) dont la résistance électrique ne varie pas sous l'effet d'un champ magnétique extérieur, dans lequel l'élément à résistance fixe (20) a une structure ayant les mêmes couches de matériau que celles de l'élément à effet de magnétorésistance (10) avec un ordre d'empilage différent, et, comme dans l'élément à effet de magnétorésistance (10), une surface latérale et une surface supérieure entière de l'élément à résistance fixe (20) sont recouvertes de la couche d'oxyde d'aluminium (31), des couches d'électrode respectives (16, 19) sont connectées électriquement à des extrémités respectives de l'élément à résistance fixe (20) et disposées respectivement sur la couche d'oxyde d'aluminium (31), et la couche d'oxyde de silicium (32) est disposée sur les couches d'électrode (16, 19) et la couche d'oxyde d'aluminium (31) placées sur l'élément à résistance fixe (20).

3. Dispositif de détection magnétique (1) selon la revendication 1 ou 2, dans lequel le circuit intégré (3) est placé sur le substrat (2 ; 44) et est recouvert d'une couche d'isolant (40), la partie d'élément de résistance (4) est placée sur la couche d'isolant (40), et la partie d'élément de résistance (4) sur la couche d'isolant (40) et le circuit intégré (3) sur le substrat (2 ; 44) sont connectés de façon conductrice l'un à l'autre.

4. Dispositif de détection magnétique (1) selon l'une quelconque des revendications 1 à 3, dans lequel la couche d'oxyde d'aluminium (31) a une épaisseur moyenne comprise dans l'intervalle de 20 à 80 nm.

5. Dispositif de détection magnétique (1) selon l'une quelconque des revendications 1 à 4, dans lequel la couche d'oxyde de silicium (32) a une épaisseur moyenne comprise dans l'intervalle de 20 à 120 nm.

6. Procédé de production de dispositifs de détection magnétique (1) comprenant chacun, sur un substrat (44), une partie d'élément de résistance (4) comportant un élément à effet de magnétorésistance (10) qui utilise un effet de magnétorésistance dans lequel la résistance électrique varie sous l'effet d'un champ magnétique extérieur, et un circuit intégré (3) étant connecté à la partie d'élément de résistance (4) et délivrant un signal de détection de champ magnétique basé sur une variation de la résistance électrique de l'élément à effet de magnétorésistance (10), comprenant :
(a) une étape de formation d'une pluralité de circuits intégrés (3) et les parties d'élément de résistance (4) sur le substrat (44) ;
(b) une étape de couverture d'une surface latérale (10b) et d'une surface supérieure entière des éléments à effet de magnétorésistance (10) avec une couche d'oxyde d'aluminium (Al₂O₃) (31) comportant des trous traversants respectifs (31a) positionnés sur des extrémités respectives (10a) de l'élément à effet de magnétorésistance correspondant (10) ;
(c) une étape de pose de couches d'électrode respectives (15, 18) depuis l'intérieur du trou traversant respectif (31a) sur la couche d'oxyde d'aluminium (31), de telle manière que les couches d'électrode (15, 18) sont connectées chacune électriquement à une extrémité respective (10a) de l'élément à effet de magnétorésistance correspondant (10) ;
(d) une étape de formation d'une couche d'oxyde de silicium (SiO₂) (32) sur les couches d'électrode (15, 18) et la couche d'oxyde d'aluminium (31) formée sur les éléments à effet de magnétorésistance ; et
(e) une étape de découpage en dés du substrat (44) pour chaque dispositif (1) pour obtenir les puces individuelles dans un état dans lequel la couche d'oxyde de silicium (32) est exposée, tout en pulvérisant un liquide nettoyant abrasif (W).

7. Procédé de production de dispositifs de détection magnétique (1) selon la revendication 6, dans lequel l'étape (a) comprend :
(a-1) une étape de formation d'une pluralité de circuits intégrés (3) sur le substrat (44) ;
(a-2) une étape de couverture des circuits intégrés (3) avec une couche d'isolant (40) ; et
(a-3) une étape de formation d'une pluralité de parties d'élément de résistance (4) sur le substrat (44) de manière telle qu'elles sont connectées de façon conductrice au circuit intégré correspondant (3).

8. Procédé de production de dispositifs de détection magnétique (1) selon la revendication 6 ou 7, dans lequel les parties d'élément de résistance (4) comprennent chacune un élément à résistance fixe (20) dont la résistance électrique ne varie pas sous l'effet d'un champ magnétique extérieur, les éléments à résistance fixe (20) sont formés chacun des mêmes couches de matériau que celles de l'élément à effet de magnétorésistance (10) avec un ordre d'empilage différent, et, comme dans l'élément à effet de magnétorésistance (10),
des surfaces latérales respectives et des surfaces supérieures entières des éléments à résistance fixe (20) sont recouvertes de la couche d'oxyde d'aluminium (31) à l'étape (b) ;
des couches d'électrode (16, 19) qui sont connectées chacune à une extrémité de l'élément à résistance fixe correspondant (20) sont formées sur la couche d'oxyde d'aluminium (31) à l'étape (c) ; et
la couche d'oxyde de silicium (32) est formée sur les couches d'électrode (16, 19) par dessus la couche d'oxyde d'aluminium (31) formée sur l'élément à résistance fixe (20) à l'étape (d).
